# EUROPEAN PATENT SPECIFICATION

(11) **EP 1 066 565 B1**
(45) Date of publication and mention of the grant of the patent: **12.03.2003**
(21) Application number: 98913386.3
(22) Date of filing: 02.04.1998
(51) Int. Cl.: G06F 11/267

(54) **INTEGRATED CIRCUIT ARCHITECTURE HAVING AN ARRAY OF TEST CELLS PROVIDING FULL CONTROLLABILITY FOR AUTOMATIC CIRCUIT VERIFICATION**
INTEGRIERTE SCHALTUNGSARCHITEKTUR MIT PRÜFZELLEMATRIX ZUR BEREITSTELLUNG VON VOLLSTEUERBARKEIT FÜR AUTOMATISCHE SCHALTUNGSPRÜFUNG
ARCHITECTURE DE CIRCUIT INTEGRE PRESENTANT UNE MATRICE DE CELLULES DE TEST ASSURANT UN CONTROLE TOTAL POUR LE TEST DE CIRCUITS AUTOMATIQUE

(43) Date of publication of application: 10.01.2001
(73) Proprietor: Lightspeed Semiconductor Corporation, Sunnyvale, CA 94086 (US)
(72) Inventor: OSANN, Robert, Jr., Los Altos, CA 94024 (US)
(74) Representative: Dixon, Philip Matthew
(86) International application number: US9806567
(87) International publication number: WO99052034

(56) References cited:
- JP-A- 6 109 816
- US-A- 5 528 600
- FRAKE S O ET AL: "A SCAN-TESTABLE MASK PROGRAMMABLE GATE ARRAY FOR CONVERSION OF FPGA DESIGNS" PROCEEDINGS OF THE CUSTOM INTEGRATED CIRCUITS CONFERENCE, BOSTON, MAY 3 - 6, 1992, no. CONF. 14, 3 May 1992, pages 27.3.1-27.3.4, XP000340969 INSTITUTE OF ELECTRICAL AND ELECTRONICS ENGINEERS

## Description

### FIELD OF THE INVENTION

This invention relates to imbedded test structures for integrated circuits, and in particular to structures for testing those devices known as Application Specific Integrated Circuits or ASICs.

### BACKGROUND OF THE INVENTION

This invention addresses the problem of testing complex digital integrated circuits. Many families of integrated circuits fall into the category known as ASICs. The most prolific of these is known as Gate Arrays. Gate Arrays are usually prefabricated up to a certain stage (typically through all steps except metalization). The metal patterns are then configured according to the needs of the user's application. For these types of ASICs, it is necessary to test the circuit after the fabrication process is completed to insure the integrity of the circuit.

Today, virtually all such testing is done by applying a stream of test vectors to the integrated circuit device. A test vector is a pattern of signal values, some of which are applied to the integrated circuit device, and some of which represent an expected response from the integrated circuit device. The important point is that these vectors are applied to the periphery of the integrated circuit device, in a sequence which corresponds to a proper operational sequence of the integrated circuit device's internal circuitry. Most important is that this stream of vectors must be created and that the burden of this tedious task almost always falls on the user himself.

There have been many attempts to provide software which creates these vectors automatically. Unfortunately, none of these attempts have produced a solution which works for the majority of user applications. Automated solutions which functionally exercise a circuit work best when the user's application is implemented in regular, synchronous circuits. To further automate the testing of such synchronous designs, engineers have often added test circuitry to integrated circuits which is known as "scan test" circuitry, also known as "LSSD" and "boundary scan" circuitry. Examples of this type of test circuit are many, and include U.S. Patents No.4,488,259 to Mercy, No.4,441,075 to McMahon, No.4,780,874 to Lenoski, and No.4,682,329 to Kluth, among others.

Scan test structures rely on stages of registers placed between blocks of combinatorial logic where extra circuitry has been added to allow the register contents to be shifted either in or out to allow the initialization or observation of logic states during testing. Unfortunately, a great many engineers don't design fully synchronous circuits where this type of structure can be used.

Attempts have also been made to add various forms of imbedded test circuitry aimed at testing integrated circuits regardless of what design style was employed by the designer. One of these is shown in U.S. Pat No. 4,739,250 to Tanizawa where a gate array comprised of logic cells has a separate access circuit attached to an input of each logic cell, this access circuit being able to force a specific logic value at the output of the logic cell under control of row and column selection wires. This scheme can test every logic cell and connection, but only if they are of the simple NAND or NOR variety. It cannot arbitrarily apply any pattern to the inputs of all logic cells due to the limitation of the row and column addressing which controls the access circuits which, in turn, drive the test input of each logic cell. While it is possible to construct a gate array which uses simple NAND or NOR gates as the logic cell, a more complex logic cell is generally more effective when test circuitry is to be added on a per-cell basis.

Another test circuit which is intended for integrated circuits which may use either synchronous or non-synchronous designs is shown in U.S. Pat No. 4,749,947 to Gheewala. This approach adds a row and column grid which connects to transistor pass-gates to selectively observe or drive a net in the user's circuit. This circuit is intended primarily to provide complete observability when used in conjunction with automatic test vector generation software. It has a limited ability to drive signals in the circuit, again due to limitations inherent in row and column addressing. As with the previous example, this test architecture cannot arbitrarily apply any pattern to the inputs of all logic cells.

Yet another example of prior art test circuits is U.S. Pat No. 4,752,729 to Jackson. Although this circuit appears to be intended mostly for applying patterns useful for life-testing a device, its technique has some application in general circuit test. Here, interface circuits are inserted at various points within an integrated circuit. Each interface circuit controls the value of the logic signal which passes through the particular net under control of test signals which come from the exterior of the device and are connected in common to all interface circuits. Interface circuits can allow a signal simply to pass through or alternately to be forced to a logic "1" or "0" value. It is important to note that since all interface circuits follow the same test signals, it is impossible to use this scheme for applying any arbitrary pattern to any logic circuit within the integrated circuit.

Each of the imbedded test circuits in the last three examples has some ability to test an integrated circuit device regardless of whether the designer chose synchronous or asynchronous design techniques. However, none of these can fully control all the inputs of an internal circuit simultaneously and thus test that circuit by applying any arbitrary pattern to its inputs. It is this controllability that has been lacking and thus prevented an integrated circuit to be fully tested for all possible design implementations, using an imbedded test circuit.

US 5528600 to Ayat discloses a circuit for observing and controlling inputs and outputs of a function circuit module.

### SUMMARY OF THE INVENTION

The object of the present invention as defined by the independent claims is to provide, in an integrated circuit device containing multiple logic cells, imbedded test circuitry which does not require a particular design technique on the part of the user, or a particular logic cell structure (in other words, the designer may use synchronous or asynchronous design techniques). This imbedded test circuitry can also verify the integrity of the entire device without any knowledge of the operation of the implemented circuit as a whole. To accomplish this, a new architecture is disclosed which provides the ability to arbitrarily force any, combination of logic values to be simultaneously driven onto any combination of internal nets. This allows all of the connections to each logic cell, and the logic cell itself, to be verified by applying a set of arbitrary test patterns to all of the inputs of each logic cell individually.

To apply any arbitrary test pattern to the inputs of a logic cell, the present invention provides test storage elements which are distributed throughout the integrated circuit device and control test circuits which determine the logic state on selected logic cell outputs within the integrated circuit device. These test circuits which allow any logic value to be forced on a logic cell output are inserted into each logic cell just before the logic cell output. As the addition of these circuits in series with the logic cells adds some delay to any logic signal passing through a logic cell, it is a further object of this invention to combine the test storage elements and added test circuits so as to minimize any added delay or additional numbers of transistors due to the presence of the imbedded test circuitry.

### BRIEF DESCRIPTION OF THE DRAWINGS

Fig. 1 shows a portion of the logic cell based array of an integrated circuit utilizing the present invention.

Fig. 2 shows an expanded view of a logic cell showing the Logic Function Generator along with the Output Driver and Test Latch.

Fig. 3 shows an expanded view of an embodiment of one logic cell according to the invention having greater flexibility.

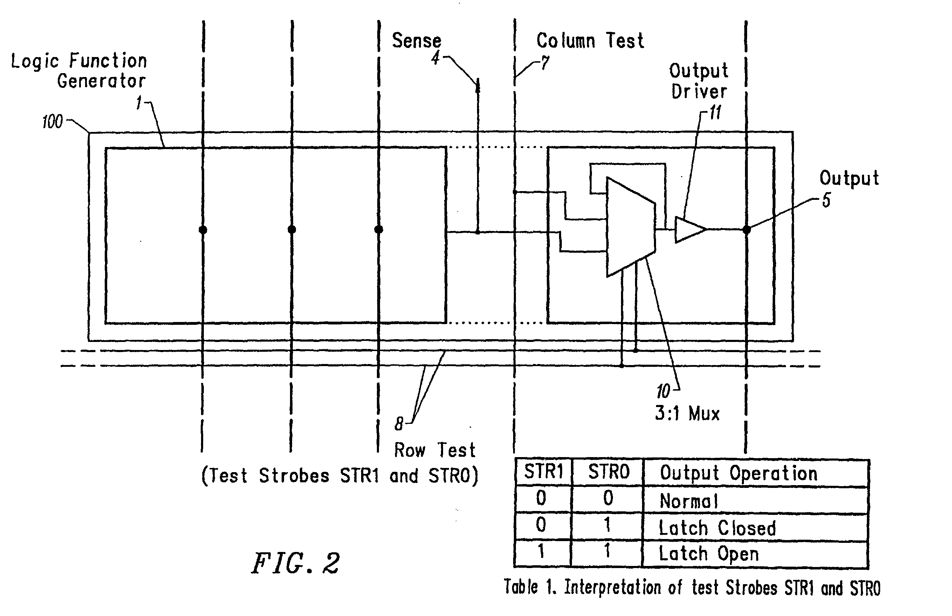

Table 1 shows how the value encoded in the Test Strobe bits of the circuit implementation of Fig. 2 affect the operation of that circuit.

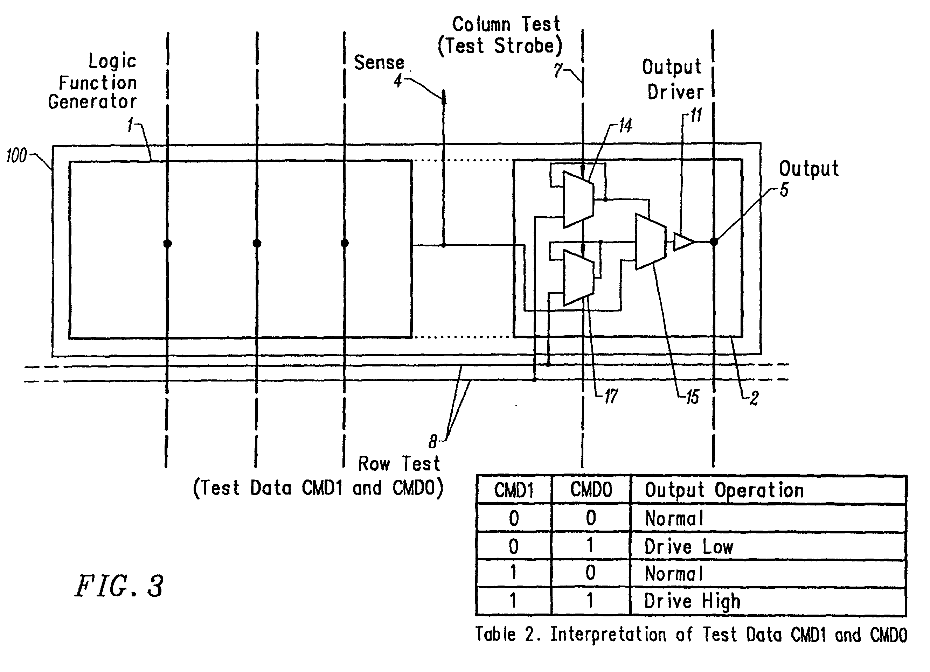

Table 2 shows how the value encoded in the Test Data bits of the circuit implementation of Fig. 3 affect the operation of that circuit.

The circuit of figure 2 is not an embodiment of the invention.

### DETAILED DESCRIPTION

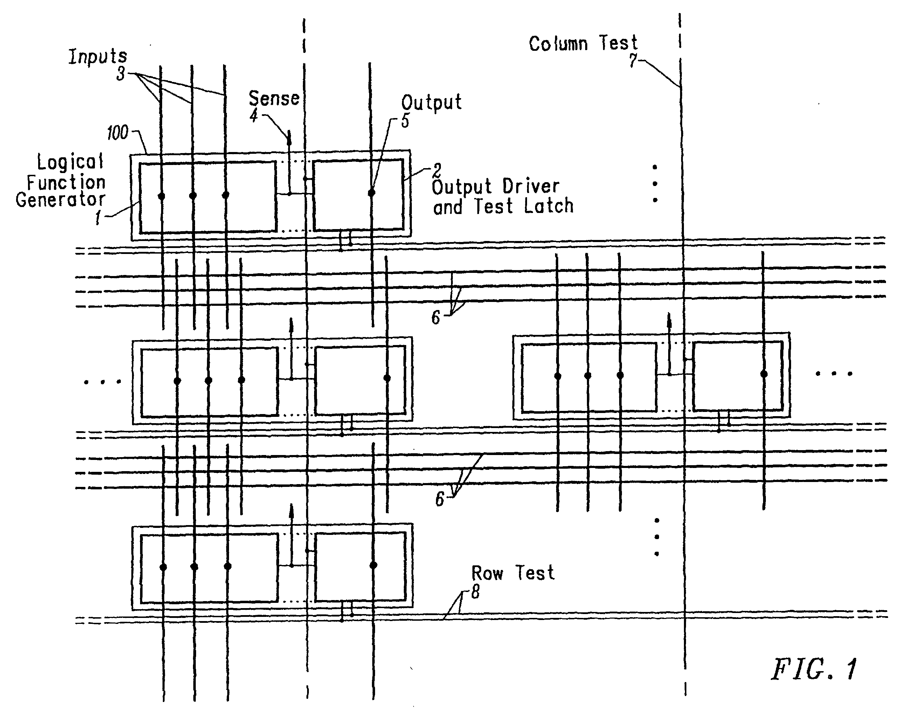

The present invention requires a logic cell based array approach as shown in Fig. 1. In accordance with the invention, each logic cell 100 is made up of two parts, the Logic Function Generator 1 and the Output Driver and Test Latch 2, which is inserted between the outputs of any driven circuitry (i.e., the logic function generator) and the logic cell output which would otherwise be connected to the logic function generator. There may be any number of inputs 3 to Logic Function Generator 1. The output of the Logic Function Generator 1 is connected to both the input of the Output Driver and Test Latch 2 and a sensing circuit (not shown). Many structures of sensing circuitry are known in the art and are therefore not mentioned here. The sensing circuit must be able to pass a logic value from the sense signal 4 to an external pin of the integrated circuit device. The output 5 of the Output Driver and Test Latch 2 may be connected to any number of inputs of other logic cells by way of routing tracks 6.

Output Driver and Test Latch 2 has a plurality of additional test inputs which are dedicated to the purpose of testing the device. These test inputs include the Row Test bits 8 and the Column Test bits 7. These groups of test bits are driven along the rows and columns formed by the logic cells 100. Which group is chosen to drive the rows, and which the columns, is arbitrary. In the configuration shown, each Column Test bit 7 is applied to all the logic cells 100 in a column, and the Row Test bits 8 (each one common to all logic cells 100 in a row) are applied to the rows.

As shown in Table 1, in the example circuit of Fig. 2 there are two Row Test bits 8, here named Test Strobes STR0 and STR1, which define three modes of operation: Normal, Latch Open (where a new test condition is entered by allowing a new Test Data value to be incorporated), and Latch Closed (where the test condition is frozen).

One circuit for Output Driver and Test Latch 2 is shown in Fig. 2. Here, in Fig. 2, the test storage element is implemented with a latch made from a 3-to-1 Mux 10. This Test Latch then feeds the logic cell's Output Driver 11. It is important to note that, by combining in the same Mux 10, the test circuit which selects normal or test data as well as the Test Latch, fewer transistors will be necessary to implement the imbedded test function while any extra delay for logic signals passing through the Test Latch during normal operation is minimized.

Of course, other types of circuitry may be used for the test storage element which is here, in Fig. 2, implemented by a Test Latch. In addition to edge-triggered devices such as flip-flops, it is also acceptable to use dynamic storage elements where stored information may be lost after some time period has passed. Dynamic storage elements are acceptable when the number of nets which must be driven to test one particular logic cell is relatively small. Here, the test cycle time is relatively small compared with the retention time of the dynamic storage elements.

One embodiment is shown in Figure 3. Here, a test command is applied to all of the logic cells 100 in a row via row Test bits 8 (here named Test Data bits CMD0 and CMD1) and subsequently, Column Test 7, or Test Strobes, are applied to those logic cells 100 where it is desired that the test command take effect. This allows some logic cells in a row to be placed in a test condition (e.g., drive a high or low test value), while other logic cells in the same row are left in a normal condition where the output of Logic Function Generator 1 is passed to the Output Driver 11. To accomplish this, 2-to-1 Mux 14 stores whether the logic cell 100 will be placed in a normal or test condition. The output of Mux 14 controls another Mux 15 which selects either the output of the Logic Function Generator 1 or the output of Mux 17, which stores a test value (a high or low value).

The embodiment shown in Fig. 3 provides a more flexible implementation than that of Fig. 2 in that a first logic cell can pass through the logic value generated by its Logic Function Generator to some driven logic cell. Meanwhile, other logic cells provide test values to control both the first logic cell and any driven logic cells. This logic value from the first logic cell can then be passed through to the output of the Logic Function Generator 1 of the driven logic cell where it is observed by a sensing circuit. In this way, the path from logic cell inputs 3 to the outputs 5 of Output Driver and Test Latch 2 can be tested. This is important since, during the testing of a single logic cell, the output logic value is available at the Sense signal 4 before it is applied to output selection Mux 15.

Even though imbedded test circuitry for a logic cell based array is not specifically shown with tri-state output circuits to implement the outputs of the Output Driver and Test Latch circuits, such a configuration is easily tested by the embodiment of Fig. 3, as a logic cell output which controls a particular tri-state output can also be forced to any desired logic value in the same manner. To verify that an output with tri-state capability of a logic cell under test has entered a high impedance condition, it is necessary to provide a pull-up resistor through which the output 5 of the Output Driver and Test Latch can connect to a known logic value so that the output 5 will be pulled to that known value when placed in a high impedance condition.

## Claims

1. An integrated circuit, comprising:
a prefabricated array of logic cells (100), couplable to form an arbitrary circuit, wherein a plurality of logic cells (100) in said array each includes:
a cell output (5);
a logic function generator (1); and
a test circuit (2), operably coupled to said cell output (5) and to said logic function generator (1),
wherein the test circuit (2) comprises a first test input (8) arranged to receive a mode selection signal (CMD0), and a second test input (8) arranged to receive a test logic value (CMD1), and the test circuit (2) is operable in a first mode of operation to pass said test logic value (CMD1) to said cell output (5) and operable in a second mode of operation to pass a generated logic value from said logic function generator (1) to said cell output (5), the mode of operation of said test circuit (2) being determined by said mode selection signal (CMD0), and
wherein said test circuit (2) forms part of each of said plurality of logic cells (100) in said prefabricated array of logic cells prior to coupling said prefabricated array of logic cells to form said arbitrary circuit and regardless of the arbitrary circuit to be ultimately formed by coupling said prefabricated array of logic cells,
**characterised in that** said test circuit (2) further comprises a storage unit (14, 17) and a third test input (7) arranged to receive a hold signal, said storage unit (14, 17) being arranged to store, in response to said hold signal, said mode selection signal (CMD0) and said test logic value (CMD1), such that the test circuit (2) in some logic cells in said array of logic cells is operable in said first mode of operation while simultaneously the test circuit (2) in other logic cells in said array of logic cells is operable in said second mode of operation.

2. The integrated circuit of claim 1, wherein each logic cell (100) in said array further includes a sense output (4), coupled to said logic function generator (1), to carry said generated logic value.

3. The integrated circuit of claim 2, wherein said sense output (4) carries said generated logic value when said test circuit (2) is operating in said first mode of operation and when the test circuit (2) is operating in said second mode of operation.

4. The integrated circuit according to any preceding claim, wherein said first test input (8) is a row test input and said third test input (7) is a column test input.

5. The integrated circuit according to any preceding claim, wherein, when said logic cells (100) are coupled to form said arbitrary circuit, the logic function generator (1) in some of said logic cells in said array of logic cells implements a synchronous function while the logic function generator (1) in other of said logic cells in said array of logic cells implements an asynchronous function.

6. The integrated circuit according to any preceding claim, wherein said storage unit includes a latch.

7. The integrated circuit according to any preceding claim, wherein said storage unit includes a multiplexor (14, 15, 17).

8. The integrated circuit of claim 7, wherein said multiplexor is configured to be operable as a latch.

9. The integrated circuit of claim 7 or 8, wherein said storage unit includes a plurality of multiplexors (14, 15, 17).

10. The integrated circuit of claim 9, wherein at least two (14, 17) of said plurality of multiplexors are each configured to be operable as a latch.

11. The integrated circuit of any preceding claim, wherein the storage unit is a one-bit test storage unit.

12. The integrated circuit according to any preceding claim, wherein said storage includes a dynamic storage element.

13. The integrated circuit according to any preceding claim, wherein said cell output (5) in each of said plurality of logic cells is coupled to a driver.

14. The integrated circuit according to any preceding claim, wherein:
said cell output (5) is a tri-state output; and
said logic cell further includes a pull-up resistor coupled to said cell output.

15. A method of testing the integrated circuit of any preceding claim, comprising the steps of:
applying a first mode selection signal (CMD0) to said first input (8) of a first logic cell (100) in said array of logic cells to select a test mode of operation for said test circuit (2) in said first logic cell;
applying a test value (CMD0) to said second input (8) of said first logic cell;
passing, by said test circuit (2) of said first logic cell, said test value (CMD0) to said cell output (5) of said first logic cell;
holding, by said test circuit of said first logic cell, said test value on said cell output (5) of said first logic cell;
applying, while said first logic cell (100) is in said test mode of operation, a second mode selection signal to said first input (8) of a second logic cell to select a pass-through mode of operation for said test circuit of said second logic cell to pass a generated logic value from said logic function generator (1) of said second logic cell to said cell output (5) of said second logic cell.

16. The method of claim 16, wherein said step of applying a test value to said second input (8) of said first logic cell precedes said step of applying a first selection signal to said first input of said first logic cell.

17. The method of claim 16 or 17, further including the step of applying a third selection signal to said first input of said first logic cell to select a pass-through mode of operation for said test circuit of said first logic cell to pass said generated logic value of said first logic cell to said cell output (5) of said first logic cell.

## Patentansprüche

1. Integrierter Schaltkreis mit:
einem vorgefertigten Feld logischer Zellen (100), die koppelbar sind, um einen beliebigen Schaltkreis zu bilden, wobei eine Vielzahl logischer Zellen (100) in dem Feld jeweils enthalten:
eine Zellenausgabe (5),
einen Logikfunktionsgenerator (1), und
einen Testschaltkreis (2), der wirksam bzw. betriebsfähig mit der Zellenausgabe (5) und dem Logikfunktionsgenerator (1) gekoppelt ist,
wobei der Testschaltkreis (2) eine erste Testeingabe (8) aufweist, die angeordnet ist, um ein Moduswählsignal (CMD0) aufzunehmen bzw. zu empfangen und eine zweite Testeingabe (8), die angeordnet ist, um einen Testlogikwert (CMD1) aufzunehmen, und wobei der Testschaltkreis (2) betriebsbereit in einem ersten Betriebsmodus ist, um den Testlogikwert (CMD1) zu der Zellenausgabe (5) durchzureichen, und betriebsbereit in einem zweiten Betriebsmodus ist, um einen erzeugten Logikwert von dem Logikfunktionsgenerator (1) zu der Zellenausgabe (5) durchzureichen, wobei der Betriebsmodus des Testschaltkreises (2) durch das Moduswählsignal (CMD0) bestimmt ist, und
wobei der Testschaltkreis (2) einen Teil jeder der Vielzahl logischer Zellen (100) in dem vorgefertigten Feld logischer Zellen bildet vor dem Koppeln des vorgefertigten Felds logischer Zellen, um den beliebigen Schaltkreis zu bilden, und ungeachtet des beliebigen Schaltkreises, um schließlich durch Koppeln des vorgefertigten Feldes logischer Zellen gebildet zu sein,
**dadurch gekennzeichnet, daß** der Testschaltkreis (2) weiterhin eine Speichereinheit (14, 17) und eine dritte Testeingabe (7) aufweist, die angeordnet ist, um eine Haltesignal zu empfangen, wobei die Speichereinheit (14, 17) angeordnet ist, um als Reaktion auf das Haltesignal das Moduswählsignal (CMD0) und den Testlogikwert (CMD1) zu speichern, so daß der Testschaltkreis (2) in einigen logischen Zellen in dem Feld logischer Zellen in dem ersten Betriebsmodus betriebsfähig ist, während gleichzeitig der Testschaltkreis (2) in anderen logischen Zellen in dem Feld logischer Zellen in dem zweiten Betriebsmodus betriebsfähig ist.

2. Integrierter Schaltkreis nach Anspruch 1, bei dem jede logische Zelle (100) in dem Feld weiterhin eine Meß- bzw. Prüfausgabe (4) aufweist, die mit dem Logikfunktionsgenerator (1) gekoppelt ist, um den erzeugten Logikwert zu übertragen.

3. Integrierter Schaltkreis nach Anspruch 2, bei dem die Meßausgabe (4) den erzeugten Logikwert überträgt, wenn der Testschaltkreis (2) in dem ersten Betriebsmodus arbeitet und wenn der Testschaltkreis (2) in dem zweiten Betriebsmodus arbeitet.

4. Integrierter Schaltkreis nach einem der vorstehenden Ansprüche, bei dem die erste Testeingabe (8) eine Reihentesteingabe ist und die dritte Testeingabe (7) eine Spaltentesteingabe ist.

5. Integrierter Schaltkreis nach einem der vorstehenden Ansprüche, bei dem, wenn die logischen Zellen (100) gekoppelt sind, um den beliebigen Schaltkreis zu bilden, der Logikfunktionsgenerator (1) in einigen der logischen Zellen in dem Feld logischer Zellen eine synchrone Funktion implementiert, während der Logikfunktionsgenerator (1) in anderen der logischen Zellen in dem Feld logischer Zellen eine asynchrone Funktion implementiert.

6. Integrierter Schaltkreis nach einem der vorstehenden Ansprüche, bei dem die Speichereinheit eine Kippschaltung bzw. Latch aufweist.

7. Integrierter Schaltkreis nach einem der vorstehenden Ansprüche, bei dem die Speichereinheit einen Multiplexer (14, 15, 17) aufweist.

8. Integrierter Schaltkreis nach Anspruch 7, bei dem der Multiplexer konfiguriert ist, um als ein Kippschalter zu arbeiten.

9. Integrierter Schaltkreis nach Anspruch 7 oder 8, bei dem die Speichereinheit eine Vielzahl von Multiplexern (14, 15, 17) aufweist.

10. Integrierter Schaltkreis nach Anspruch 9, bei dem zumindest zwei (14, 17) der Vielzahl von Multiplexern jeweils konfiguriert sind, um als ein Kippschalter zu arbeiten.

11. Integrierter Schaltkreis nach einem der vorstehenden Ansprüche, bei dem die Speichereinheit eine Ein-Bit Test Speichereinheit ist.

12. Integrierter Schaltkreis nach einem der vorstehenden Ansprüche, bei dem der Speicher ein dynamisches Speicherelement aufweist.

13. Integrierter Schaltkreis nach einem der vorstehenden Ansprüche, bei dem die Zellenausgabe (5) in jeder der Vielzahl logischer Zellen mit einem Treiber gekoppelt ist.

14. Integrierter Schaltkreis nach einem der vorstehenden Ansprüche, bei dem:
die Zellenausgabe (5) eine Drei-Zustands- bzw. tri-state Ausgabe ist, und
die logische Zelle weiterhin eine pull-up Widerstand aufweist, der mit der Zellenausgabe gekoppelt ist.

15. Verfahren zum Testen des integrierten Schaltkreises nach einem der vorstehenden Ansprüche, mit folgenden Schritten:
Anwenden bzw. Anlegen eines ersten Moduswählsignals (CMD0) an die erste Eingabe (8) einer ersten logischen Zelle (100) in dem Feld logischer Zellen, um einen Testmodus des Betriebs für den Testschaltkreis (2) in der ersten logischen Zelle auszuwählen,
Anlegen eines Testwertes (CMD0) an die zweite Eingabe (8) der ersten Logikzelle,
Durchreichen durch den Testschaltkreis (2) der ersten Logikzelle des Testwertes (CMD0) der Zellenausgabe (5) der ersten logischen Zelle,
Halten durch den Testschaltkreis der ersten logischen Zelle des Testwertes auf der Zellenausgabe (5) der ersten logischen Zelle,
Anlegen, während die erste logische Zelle (100) im Testmodus des Betriebs ist, eines zweiten Moduswählsignals an die erste Eingabe (8) einer zweiten logischen Zelle, um einen Durchreichmodus des Betriebs für den Testschaltkreis der zweiten logischen Zelle auszuwählen, um einen generierten Logikwert von dem Logikfunktionsgenerator (1) der zweiten logischen Zelle zu der Zellenausgabe (5) der zweiten logischen Zelle zu übertragen.

16. Verfahren nach Anspruch 16, bei dem der Schritt des Anlegens eines Testwertes an die zweite Eingabe (8) der ersten logischen Zelle dem Schritt des Anlegens eines ersten Auswählsignals an die erste Eingabe der ersten logischen Zelle vorangeht.

17. Verfahren nach Anspruch 16 oder 17, das weiterhin den Schritt des Anlegens eines dritten Auswählsignals an die erste Eingabe der ersten Logikzelle umfaßt, um einen Durchreichmodus des Betriebs für den Testschaltkreis der ersten logischen Zelle auszuwählen, um den generierten Logikwert der ersten logischen Zelle zu der Zellenausgabe (5) der ersten logischen Zelle zu übertragen.

## Revendications

1. Circuit intégré, comprenant :
une matrice préfabriquée de cellules logiques (100), pouvant être couplée de façon à former un circuit arbitraire, dans lequel une pluralité de cellules logiques (100) de ladite matrice comprennent chacune :
une sortie de cellule (5) ;
un générateur de fonction logique (1) ; et
un circuit de contrôle (2), couplé à ladite sortie de cellule (5) et au dit générateur de fonction logique (1),
dans lequel le circuit de contrôle (2) comprend une première entrée de contrôle (8) conçue pour recevoir un signal de sélection de modes (CMD0), et une seconde entrée de contrôle (8) conçue pour recevoir une valeur logique de contrôle (CMD1), et dans lequel le circuit de contrôle (2) peut être utilisé dans un premier mode de fonctionnement pour transmettre ladite valeur logique de contrôle (CMD1) à ladite sortie de cellule (5) et peut être utilisé dans un second mode de fonctionnement pour transmettre une valeur logique générée du dit générateur de fonction logique (1) vers ladite sortie de cellule (5), le mode de fonctionnement du dit circuit de contrôle (2) étant déterminé par ledit signal de sélection de modes (CMD0), et
dans lequel ledit circuit de contrôle (2) forme une partie de chacune de ladite pluralité de cellules logiques (100) dans ladite matrice préfabriquée de cellules logiques avant le couplage à ladite matrice préfabriquée de cellules logiques de façon à former ledit circuit arbitraire et sans tenir compte du circuit arbitraire formé ensuite par couplage à ladite matrice préfabriquée de cellules logiques,
**caractérisé en ce que** ledit circuit de contrôle (2) comprend en outre une unité de stockage (14, 17) et une troisième entrée de contrôle (7) conçue pour recevoir un signal de conservation, ladite unité de stockage (14, 17) étant conçue pour stocker, en réponse au dit signal de conservation, ledit signal de sélection de modes (CMD0) et ladite valeur logique de contrôle (CMD1), de sorte que le circuit de contrôle (2) puisse être utilisé dans ledit premier mode de fonctionnement dans certaines cellules logiques de ladite matrice de cellules logiques pendant que le circuit logique (2) est utilisé simultanément dans ledit second mode de fonctionnement dans d'autres cellules logiques de ladite matrice de cellules logiques.

2. Circuit intégré selon la revendication 1, dans lequel chaque cellule logique (100) de ladite matrice comprend en outre une sortie de détection (4), couplée au dit générateur de fonction logique (1), de façon à transporter ladite valeur logique générée.

3. Circuit intégré selon la revendication 2, dans lequel ladite sortie de détection (4) transporte ladite valeur logique générée lorsque ledit circuit de contrôle (2) fonctionne dans ledit premier mode de fonctionnement et lorsque le circuit de contrôle (2) fonctionne dans le second mode de fonctionnement.

4. Circuit intégré selon l'une des revendications précédentes, dans lequel ladite première entrée de contrôle (8) est une entrée de contrôle de ligne et ladite troisième entrée de contrôle (7) est une entrée de contrôle de colonne.

5. Circuit intégré selon l'une des revendications précédentes, dans lequel, lorsque lesdites cellules logiques (100) sont couplées de façon à former ledit circuit arbitraire, le générateur de fonction logique (1) implémente dans certaines des dites cellules logiques de ladite matrice de cellules logiques une fonction synchrone pendant que le générateur de fonction logique (1) implémente dans certaines autres cellules logiques de ladite matrice de cellules logiques une fonction asynchrone.

6. Circuit intégré selon l'une des revendications précédentes, dans lequel ladite unité de stockage comprend un circuit de verrouillage.

7. Circuit intégré selon l'une des revendications précédentes, dans lequel ladite unité de stockage comprend un multiplexeur (14, 15, 17).

8. Circuit intégré selon la revendication 7, dans lequel ledit multiplexeur est configuré pour fonctionner comme un circuit de verrouillage.

9. Circuit intégré selon la revendication 7 ou 8, dans lequel ladite unité de stockage comprend une pluralité de multiplexeurs (14, 15, 17).

10. Circuit intégré selon la revendication 9, dans lequel au moins deux (14, 17) de ladite pluralité de multiplexeurs sont chacun configurés pour fonctionner comme des circuits de verrouillage.

11. Circuit intégré selon l'une des revendications précédentes, dans lequel l'unité de stockage est une unité de stockage de contrôle de un bit.

12. Circuit intégré selon l'une des revendications précédentes, dans lequel ledit stockagc comprend un élément de stockage dynamique.

13. Circuit intégré selon l'une des revendications précédentes, dans lequel ladite sortie de cellule (5) de chacune de la pluralité de cellules logiques est couplée à un circuit pilote.

14. Circuit intégré selon l'une des revendications précédentes, dans lequel :
ladite sortie de cellule (5) est une sortie à trois états ; et
ladite cellule logique comprend en outre une résistance de polarisation à l'alimentation couplée à ladite sortie de cellules.

15. Procédé permettant de contrôler le circuit intégré selon l'une des revendications précédentes, comprenant les étapes consistant à :
appliquer un premier signal de sélection de modes (CMD0) à ladite première entrée (8) d'une première cellule logique (100) de ladite matrice de cellules logiques de manière à sélectionner un mode de contrôle de fonctionnement pour ledit circuit de contrôle (2) dans ladite première cellule logique ;
appliquer une valeur de contrôle (CMD1) à ladite seconde entrée (8) de ladite cellule logique ;
transmettre, par ledit circuit de contrôle (2) de ladite première cellule logique, ladite valeur de contrôle (CMD0) vers ladite sortie de cellule (5) de ladite première cellule logique ;
conserver, par ledit circuit de contrôle de ladite première cellule logique, ladite valeur de contrôle au niveau de ladite sortie de cellule (5) de ladite cellule logique ;
appliquer, pendant que ladite première cellule logique (100) est dans ledit mode de contrôle de fonctionnement, un second signal de sélection de modes à ladite première entrée (8) d'une seconde cellule logique de manière à sélectionner un mode de passage de fonctionnement pour ledit circuit de contrôle de ladite seconde cellule logique pour transmettre une valeur logique générée du dit générateur de fonction logique (1) de ladite second cellule logique vers ladite sortie de cellule (5) de ladite seconde cellule logique.

16. Procédé selon la revendication 16, dans lequel ladite étape d'application d'une valeur de contrôle à ladite seconde entrée (8) de ladite première cellule logique précède l'étape d'application d'un premier signal de sélection à ladite première entrée de ladite cellule logique.

17. Procédé selon la revendication 16 ou 17, comprenant en outre une étape d'application d'un troisième signal de sélection à ladite première entrée de ladite première cellule logique de manière à sélectionner un mode de passage de fonctionnement pour ledit circuit de contrôle de ladite première cellule logique de façon à transmettre ladite valeur logique générée de ladite première cellule logique vers ladite sortie de cellule (5) de ladite première cellule logique.
